# EUROPÄISCHE PATENTSCHRIFT

(11) **EP 1 423 330 B1**
(45) Veröffentlichungstag und Bekanntmachung des Hinweises auf die Patenterteilung: **11.09.2013**
(21) Anmeldenummer: 02754435.2
(22) Anmeldetag: 25.07.2002
(51) Int. Cl.: B81C 1/00, G01L 9/00

(54) **HALBLEITERBAUELEMENT, INSBESONDERE MEMBRANSENSOR, UND DESSEN HERSTELLUNGSVERFAHREN**
SEMICONDUCTOR COMPONENT, ESPECIALLY A MEMBRANE SENSOR, AND METHOD FOR MANUFACTURING IT
COMPOSANT SEMI-CONDUCTEUR, NOTAMMENT DETECTEUR A MEMBRANE, ET SON PROCÉDÉ DE PRODUCTION.

(30) Priorität: 07.08.2001 DE 10138759
(43) Veröffentlichungstag der Anmeldung: 02.06.2004
(73) Patentinhaber: ROBERT BOSCH GMBH, 70442 Stuttgart (DE)
(72) Erfinder: BENZEL, Hubert, 72124 Pliezhausen (DE); WEBER, Heribert, 72622 Nürtingen (DE); ARTMANN, Hans, 71106 Magstadt (DE); PANNEK, Thorsten, 70176 Stuttgart (DE); SCHAFER, Frank, 72070 Tubingen (DE)
(86) Internationale Anmeldenummer: PCT/DE2002/002731
(87) Internationale Veröffentlichungsnummer: WO 2003/016203

(56) Entgegenhaltungen:
- WO-A1-99/45583
- DE-A- 19 754 513
- DATABASE WPI Section EI, Week 200038 Derwent Publications Ltd., London, GB; Class U12, AN 2000-432097 XP002255642 & CN 1 251 945 A (TU X) 3. Mai 2000 (2000-05-03) -& US 6 359 276 B1 (TU XIANG ZHENG) 19. März 2002 (2002-03-19)
- G. LAMMEL, P. RENAUD: "Free-standing, mobile 3D porous silicon microstructures", SENSORS AND ACTUATORS A, vol. 85, no. 1-3, 25 August 2000 (2000-08-25), pages 356-360, XP004214496, Elsevier, Switzerland

## Beschreibung

Die Erfindung betrifft ein Verfahren zur Herstellung eines Halbleiterbauelements nach Anspruch 1 sowie ein Halbleiterbauelement nach Anspruch 7.

### Stand der Technik

Halbleiterbauelemente, insbesondere Membransensoren sowie Verfahren zur Herstellung von Membransensoren auf der Basis eines Halbleiterträgers, z.B. eines Siliziumwafers, auf welchem ein flächiger poröser Membranbereich als Trägerschicht für Sensorstrukturen angeordnet und unter dem Membranbereich eine Kavität zur insbesondere thermischen Isolation der Membran vorhanden ist, sind bereits bekannt geworden.

Die zur Zeit auf dem Markt befindlichen Membransensoren sind zumeist als Dünnschichtmembran-Sensoren realisiert. Hierzu werden Schichtsysteme in Dicken zwischen einigen 10 nm und einigen µm auf einem Trägersubstrat abgeschieden und danach das Trägersubstrat in vorgegebenen Bereichen entfernt, um frei tragende Membranbereiche zu erhalten. Im Membranzentrum können dann Sensorstrukturelemente angeordnet werden.

Eine weitere Möglichkeit zur Freilegung der Membran ist die Oberflächenmikromechanik (OMM), bei welcher im Allgemeinen eine Opferschicht verwendet wird, die vor der Membranabscheidung auf der Vorderseite eines Trägersubstrates aufgebracht wird. Die Opferschicht wird später von der Vorderseite des Sensors durch "Löseöffnungen" in der Membran entfernt, wodurch eine frei tragende Struktur entsteht. Diese oberflächenmikromechanischen Verfahren sind aufgrund der Notwendigkeit von separaten Opferschichten vergleichsweise aufwendig.

Aus der noch nicht veröffentlichten deutschen Patentanmeldung DE 100 325 79.3 ist ein Verfahren zur Herstellung eines Halbleiterbauelements sowie ein nach dem Verfahren hergestelltes Halbleiterbauelement bekannt, bei welchem für insbesondere einen Membransensor eine Schicht aus porösiziertem Halbleiterträgermaterial über einer Kavität angeordnet ist.

Durch diese Maßnahme kann der Aufbau eines OMM-Halbleiterbauelements erheblich vereinfacht werden, da eine zusätzlich aufgebrachte Opferschicht nicht erforderlich ist und zudem die Membran selbst bzw. ein wesentlicher Teil der Membran aus Halbleiterträgermaterial erzeugt wird.

Es hat sich jedoch in Versuchen herausgestellt, dass eine poröse Membran bereits während der Herstellung Schaden nehmen kann bzw. auch im Anwendungsfall sich eine Beschädigung unter herkömmlichen Einsatzbedingungen nicht immer sicher vermeiden lässt.

Die DE 197 54 513 A1 zeigt ein Verfahren zur Herstellung einer Mikrostruktur mit einem porösen Bereich. Dieser poröse Bereich dient dazu, einen Zugang des Umgebungsmediums zu einem durch die Mikrostruktur abgedeckten Sensor zu ermöglichen. Dabei dient die Mikrostruktur als Kappe, die beispielsweise eine Membran abdeckt.

Aus der CN 1251945 A ist ein Infrarotsensor bekannt, der eine poröse Siliziumschicht als Trägermaterial für einen thermosensitiven Widerstand oder eine thermoelektrischen Detektor verwendet.

Aus der WO 99/45583 A1 ist ein Verfahren bekannt, bei dem aus einem Substrat durch abwechselnd angelegte niedrige und hohe Stromdichten Substratmaterial herausgelöst wird. Diese wechselnden Stromdichten führen zu einer mehr oder weniger starken Herauslösung des Substratmaterials und zur Bildung freigelegter Bereiche mit angrenzenden porösen Schichten.

In der Schrift Lammel et al ("Free standing, mobile 3D porous silicon microstructures", Sensors and Actuators, Bd. 85, Nr. 1-3, Seiten 356-360) wird die Herstellung einer porösen Schicht unter Verwendung eines elektrochemischen Ätzverfahrens gezeigt. Dabei wird ein Substrat in Abhängigkeit von der angelegten Stromdichte und einer Einwirkzeit porös geätzt.

### Aufgabe und Vorteile der Erfindung

Der Erfindung liegt die Aufgabe zugrunde, eine Membranbeschädigung bei der Herstellung oder bei regelmäßig auftretenden Anwendungsfällen zu vermeiden.

Diese Aufgabe wird durch die Merkmale des Anspruchs 1, und 7 gelöst.

In den Unteransprüchen sind vorteilhafte und zweckmäßige Weiterbildungen der Erfindung angegeben.

Die Erfindung geht zunächst von einem Verfahren zur Herstellung eines Halbleiterbauelements insbesondere Membransensors mit einem Halbleiterträger aus, bei welchem für die Ausbildung von frei tragenden Strukturen für das Bauelement eine poröse Membranschicht und eine Kavität unter der porösen Membranschicht erzeugt wird. Der Kern der Erfindung liegt nun darin, dass der Halbleiterträger im Bereich der porösen Membranschicht eine zum Bereich der späteren Kavität unterschiedliche Dotierung erhält, dass das Halbleitermaterial der Membranschicht porösiziert wird, und dass das Halbleitermaterial unter dem porösizierten Halbleitermaterial zur Bereitstellung einer Kavität entfernt oder teilweise entfernt und umgelagert wird. Diese Vorgehensweise hat den Vorteil, dass die Eigenschaften der porösen Membranschicht und die Erzeugung der Kavität derart aufeinander abgestimmt werden können, dass zum Beispiel beim Ätzen der Kavität das dabei entstehende Gas möglichst ungestört durch die poröse Membranschicht entweichen kann oder im Bereich der Kavität zunächst eine Hilfsstruktur mit geeigneter, zu den Poren der Membranschicht unterschiedlicher Porengröße geschaffen wird, jeweils mit dem Ziel, eine Beschädigung der porösen Membranschicht bei der Kavitätserzeugung zu vermeiden.

Diese Vor- oder Hilfsstruktur kann dann in einem weiteren Schritt entfernt oder z.B. in einem Hochtemperaturprozess umgelagert werden.

In der Erfindung erhält der Halbleitermaterialträger im Bereich der porösen Membranschicht in lateraler und/oder vertikaler Richtung eine unterschiedliche Dotierung. Unterschiedliche Dotierungen (Art und Grad der Dotierung) führen bei der Herstellung von porösen Halbleitern, beispielsweise porösem Silizium, bei welchem regelmäßig eine elektrochemische Reaktion zwischen Flusssäure und Silizium unter anodischer Polung des Silizium-Halbleiterträger (z. B. Siliziumwafers) gegenüber einem Flusssäureelektrolyt unter ggf. einer zusätzlichen Beleuchtung des Halbleiterträgers (für n-dotierte Halbleiterbereiche) genutzt wird, zu verschieden großen Poren bzw. Porenarten. Erfindungsgemäß werden damit in lateraler und/oder vertikaler Richtung in bestimmten Membranbereichen größere Poren und/oder Poren mit höherer Porosität erzeugt, durch die das bei der Ätzung der Kavität entstehende Gas leichter entweichen kann. Auf diese Weise wird vermieden, dass die Blasenbildung bei der Ätzung der Kavität eine Beschädigung der empfindlichen porösen Membranschicht verursacht. Bei herkömmlichen porösen Membranstrukturen können die Poren häufig ein kontrolliertes, ausreichendes Entweichen von Gas aus der Kavität bei der Ätzung nicht sicherstellen, was im schlimmsten Fall mit der Zerstörung der Membran endet.

In einer besonders bevorzugten Ausgestaltung der Erfindung wird die Dotierung des Halbleitermaterials für den Randbereich und Mittenbereich der Membran derart gewählt, dass im Randbereich Mesoporen (Poren in der Größenordnung von 5 bis 50 nm) und im Mittenbereich der Membran Makroporen (Poren von größer 50 nm bis zu einigen µm) oder Mesoporen bzw. Nanoporen mit im Vergleich zum Randbereich höherer Porosität entstehen. Im Membranrandbereich mit geringer Porosität ist zum Beispiel für einen nachfolgenden Epitaxieprozess eine gute Schichtqualität möglich, während im Membranmittenbereich durch Abschnitte höherer_Porosität die Epitaxiequalität vergleichsweise geringer ist. In vielen Anwendungsfällen, z.B. im Anwendungsfall eines OMM-Drucksensors ist dies jedoch nicht von Bedeutung, da die Eigenschaften des Drucksensors hierdurch nicht verschlechtert werden.

Zum Beispiel erhält ausgehend von einem Siliziumwafer der Membranmittenbereich zur Erzeugung von Makroporen eine n-Dotierung während der Membranrandbereich für die Bereitstellung von mesoporösem Silizium mit einer p⁺-Dotierung versehen wird.

In einer weiteren besonders bevorzugten Ausgestaltung der Erfindung wird der Halbleiterträger im Bereich der Membranschicht und im Bereich der späteren Kavität derart unterschiedlich dotiert, dass im Halbleitermaterial der Membranschicht Mesoporen und im Kavitätsbereich Nanoporen (Poren von 2 bis 5 nm) mit vergleichsweise höherer Porosität als "Vorstruktur" erzeugbar sind, und dass in einem weiteren Schritt die nanoporöse Vorstruktur entfernt wird. Die Herstellung einer kleinporigen Vorstruktur verhindert die Bildung größerer Gasblasen, was den Abtransport der Gasblasen durch die poröse Membranschicht in ausreichender Weise ermöglicht. Bei dieser Vorgehensweise macht man sich außerdem die Erkenntnis zunutze, dass die "Nanostruktur" eine wesentlich höhere innere Oberfläche als die "Mesostruktur" des Membranbereichs aufweist, was in einem späteren Prozessschritt für eine geringere Oxidationsdauer genutzt werden kann. Dadurch lässt sich anschließend eine vollständig durchoxidierte Nanostruktur erzeugen, die in einem nachfolgenden Ätzprozess, z.B. einem Dampfätzprozess selektiv entfernt werden kann. Durch insbesondere einen Dampfätzprozess werden zusätzlich Probleme bei der Trocknung der Membran in der Hinsicht unterbunden, dass häufig beim Trocknen einer z.B. porösen Siliziummembran durch vertikale Kapillarkräfte ein Kleben der porösen Schicht am Substratboden auftritt, was die poröse Membranschicht unbrauchbar macht. Die Kavität lässt sich auch durch Umlagerung der nanoporösen Schicht in einem Hochtemperaturprozess erreichen. Die Mesoporen der porösen Membranschicht lassen sich zum Beispiel ausgehend von einer p⁺-Dotierung in einem Siliziumwafer (spezifischer Widerstand rund 0,02 Ωcm) bei einer Porösität von rund 10 bis 30 % und einer Schichtdicke von 0,1 bis 10 µm oder mehr durch z. B. eine Stromdichte von ungefähr 1 bis 20 mA/cm² in einer vergleichsweise hochkonzentrierten Flusssäure mit einer HF-Konzentration von ca. 30 bis 40 % erreichen. Die Herstellung der nanoporösen Vorstruktur folgt vorzugsweise auf der Basis einer p-dotierten Schicht (spezifischer Widerstand 1 bis 10 Ωcm) in einer HF-Konzentration von ca. 15 bis 40 % bei einer Stromdichte von 10 bis 80 mA/cm². Bei diesen Parametern kann über eine Schichtdicke von 1 bis 10 µm eine Porosität von größer 80 % erreicht werden.

Eine alternative Vorgehensweise bei der Bildung der Kavernenstruktur kann auch darin bestehen, dass das Halbleitermaterial unter der porösen Schicht durch Elektropolitur z. B. bei vergleichsweise höheren Stromdichten und geringeren HF-Konzentrationen direkt aufgelöst wird. Bei einem Siliziumwafer kann dies z.B. dadurch erreicht werden, dass eine Startschicht für die Ausbildung der porösen Schicht über der Kavität p⁺-dotiert und der Bereich der späteren Kavität lediglich eine p-Dotierung erhält. Beispielsweise weist die Startschicht zur Ausbildung der porösen Schicht über der Kavität eine p⁺-Dotierung mit einem spezifischen Widerstand von ungefähr 0,02 Ωcm auf. Bei einer HF-Konzentration von z.B. 30 bis 40 % und einer Stromdichte von ungefähr 1 bis 20 mA/m² kann eine Porosität von 10 bis 30 % erzielt werden. Die Schichtdicke der porösen Schicht kann dabei 1 bis 10 µm oder auch mehr betragen. Bei einem weiteren Ausführungsbeispiel, bei welchem der Membranbereich im Vergleich zum späteren Kavitätsbereich unterschiedlich dotiert ist, erhält die Startschicht für die Ausbildung der porösen Schicht über der Kavität z.B. eine n-Dotierung mit einem spezifischen Widerstand von z.B. 0,1 bis 10 Ωcm. Bei einer Stromdichte von 5 mA/cm² und einer vergleichsweise geringen HF-Konzentration von 2 bis 10 % lassen sich bevorzugt Makroporen über beispielsweise eine Schichtdicke von 1 bis 10 µm ausbilden. Die Makroporen haben den Vorteil, dass Gase bei der Herstellung der Kavität leichter durch diese entweichen können, womit einer Beeinträchtigung oder gar Zerstörung der porösen Schicht entgegen gewirkt wird.

Der Kavernenbereich wird z.B. p-dotiert, so dass sich ein spezifischer Widerstand von 1 bis 10 Ωcm ergibt. Für diesen Fall kann die Kavernenschicht unmittelbar durch Elektropolitur bei einer HF-Konzentration von 2 bis 10 % und einer Stromdichte von vorzugsweise größer 50 mA/cm² erzeugt werden. Die Kaverne lässt sich jedoch auch über eine "Vorstruktur" durch Erzeugung von Nanoporen herstellen. Die "Nanostruktur" entsteht z.B. bei einer HF-Konzentration von 15 bis 40 % bei einer Stromdichte von 2 bis 50 mA/cm² und weist vorzugsweise eine Porosität von größer 80 % auf.

Die Schichtdicken der porösen Schicht über der Kaverne und der Kavernenschicht können je nach Anwendungswunsch 1 bis 10 µm und mehr betragen.

Anstatt der p-Dotierung für die Kavernenschicht kann diese auch p⁺ oder p⁻ dotiert werden, womit der Elektropoliturbereich für die unmittelbare Herstellung der Kaverne vorzugsweise bei einer HF-Konzentration von 2 bis 10 % und einer Stromdichte von größer 50 mA/cm² realisierbar ist. Auch in diesem Fall kann eine "Vorstruktur" und weitere Prozesse zur gewünschten Kavität führen. Die Vorteile einer Membran aus Makroporen können auch bei einer Ausführungsform erreicht werden, bei welcher die Membranschicht als auch der spätere Kavernenbereich eine gleiche Dotierung, z.B. die n-Dotierung aufweist, jedoch für die Behandlung des späteren Kavernenbereichs andere Ätzparameter als für die poröse Membran zur Anwendung kommen, so dass die Kaverne unter dem Membranbereich unmittelbar durch Elektropolitur hergestellt werden kann. Beispielsweise wird eine Startschicht für den Membranbereich n-dotiert, so dass sich ein spezifischer Widerstand von 0,1 bis 10 Ωcm ergibt. Der spätere Kavernenbereich wird in gleicher Weise dotiert. In der Startschicht werden nun Makroporen über eine Schichtdicke von 1 bis 10 µm oder auch mehr bei z.B. einer Stromdichte von > 5 mA/cm² und einer HF-Konzentration von z.B. 5 bis 10 % ggf. unter einer Rückseitenbeleuchtung des Substrats.

Die Kavernenschicht wird daraufhin unmittelbar durch Elektropolitur erzeugt, was mit einer Stromdichte möglich ist, die größer ist als die Stromdichte für die Erzeugung der porösen Deckschicht.

Zur besseren Kontrolle und Einstellung der Stromdichte beim Ätzen des Halbleiterträgers zur Herstellung der porösen Membranschicht über der Kavität oder zur besseren Einstellung der Stromdichte beim Ätzen des Halbleitermaterialträgers während eines Elektropoliturprozesses zur unmittelbaren Herstellung der Kavität bzw. zur Erzeugung einer porösen Schicht im Bereich der späteren Kavität als "Vorstruktur" wird vorzugsweise die Rückseite des Halbleiterträgers, z.B. die Rückseite eines Siliziumwafers beleuchtet.

Die poröse Schicht über der Kavität lässt sich auch mit einer gleichen Dotierung, z.B. p⁺-Dotierung über beide Bereiche mit beispielsweise einem spezifischen Widerstand von 0,02 Ωcm erzeugen. Für die Startschicht, d.h. die poröse Membranschicht über der Kavität wird dann beispielsweise bei vergleichsweise hoher HF-Konzentration von 30 bis 40 % und einer Stromdichte von 1 bis 20 mA/cm² eine Porosität von 10 bis 30 % angestrebt. Anschließend kann der Kavitätsbereich unmittelbar durch Elektropolitur, z. B. bei einer HF-Konzentration von z.B. 2 bis 10 % und einer Stromdichte von größer 50 mA/cm² oder über eine später zu entfernende Vorstruktur hergestellt werden. Zur Ausbildung der Vorstruktur wird vorzugsweise bei der p⁺-Dotierung eine HF-Konzentration von 5 bis 20 %, eine Stromdichte von z.B. 2 bis 50 mA/cm² gewählt, um eine Porosität von größer 80 % zu erreichen.

Es ist jedoch auch möglich, die HF-Konzentration vergleichsweise groß wie bei der Erzeugung der Startschicht zu belassen, was jedoch zur Erzeugung einer hohen Porosität von 80 % eine Stromdichte erfordert, die größer ist als die Stromdichte bei der Herstellung der Startschicht.

Sowohl die Startschicht (poröse Membranschicht) als auch die Kavitätsschicht können je nach Vorgabe 0,1 bis 10 µm oder mehr betragen.

Für alle genannten Prozesse kann als Maskierung zur Definition des Membranbereichs für den Fall eines Siliziumwafers n-dotiertes Silizium verwendet werden. Da eine derartige Maskierschicht bei der Herstellung von porösem Silizium ebenfalls leicht angegriffen wird, kann diese durch eine isolierende Schicht beispielsweise aus Siliziumnitrit (Si₃N₄) beispielsweise in einem Low Pressure Chemical Vapour Deposition-Verfahren (LPCVD-Verfahren) hergestellt werden. Damit ist die n-dotierte Maskierschicht vor einem elektrochemischen Angriff geschützt. Eine unversehrte n-dotierte Maskierschicht ist dann vorteilhaft, wenn darauf in einem anschließenden Prozess eine epitaktische Schicht aufwachsen soll. Im Falle der Verwendung der Struktur als Membransensor kann ein Angriff der n-dotierten

Maskierungsbereiche jedoch oftmals toleriert werden.

Anstatt der Siliziumnitrit-Schicht können auch andere Schichten als Schutzschicht verwendet werden, z.B. lässt sich eine leitende Metallschicht aus Chrom/Gold mit entsprechender Dicke verwenden.

Durch eine zusätzliche Maskierung lässt sich auch die Tiefenhomogenität der lateral begrenzenden Bereiche verbessern, was insbesondere bei der Erzeugung von Makroporen sehr von Vorteil ist.

Im Weiteren geht die Erfindung von einem Halbleiterbauelement, insbesondere einem Membransensor mit einem Träger aus Halbleitermaterial aus, das zur Ausbildung von Halbleiterbauelementstrukturen eine Membran und eine unter der Membran angeordnete Kavität aufweist, wobei die Membran eine Schicht aus porösiziertem und gegebenenfalls nachbehandeltem, z.B. oxidiertem Halbleitermaterial umfasst. Der wesentliche Erfindungsaspekt liegt nun darin, dass der Grad der Porosität der Schicht in lateraler und/oder vertikaler Richtung gezielt unterschiedlich ist. Dies ermöglicht wie bereits oben ausgeführt bei der Herstellung der. Kavität insbesondere bei einem Porositätsunterschied in lateraler Richtung ein verbessertes Entweichen von beim Ätzen entstehenden Gasen durch Bereiche der porösen Schicht, die vergleichsweise höhere Porosität besitzen.

Die Porosität der Schicht im Randbereich der Membran ist geringer als im Membranmittenbereich. Damit wird ein Entweichen von Gas im Zentrum der Membran begünstigt.

Das Entweichen von Gas lässt sich nicht nur über den Grad der Porosität, sondern auch über die Porengröße regulieren. Die Gasdurchlässigkeit der porösen Schicht ist bei gleicher Porosität, aber größeren Poren erhöht.

Um eine verbesserte Gasdurchlässigkeit im Membranbereichzentrum zu begünstigen, ist vorzugsweise dort die Porengröße größer als im Membranrandbereich.

Günstigerweise ist die poröse Schicht im Membranrandbereich mesoporös und im Membranmittenbereich makroporös.

Die erfindungsgemäße Aufgabe wird auch dadurch gelöst, dass die Schicht der Membran aus porösiziertem Material durchgehend Makroporen aufweist. Die Poren mit größeren Abmessungen verbessern die Möglichkeit des Gastransportes bei der Herstellung einer Kavität. Beispielsweise wird der Membranbereich und der spätere Bereich der Kavität aus z.B. n-dotiertem Silizium erzeugt. Die poröse Schicht des Membranbereichs wird zur Bildung von Makroporen beispielsweise bei einer Stromdichte von größer 5 mA/cm² in vergleichsweise gering konzentrierter 2 bis 10%iger Flusssäure erzeugt. Zur Herstellung der Kavität wird dann die Stromdichte erhöht, was eine Porenvergrößerung und damit eine Unterhöhlung der Startschicht, die die poröse Membranschicht bildet, zur Folge hat. Das Ergebnis ist eine Kavität, die von einer makroporösen Schicht (Poren im Bereich von 100 nm bis einigen µm) überdeckt wird.

Im Weiteren wird die oben genannte Aufgabe von einem Halbleiterbauelement dadurch gelöst, dass innerhalb der porösen Schicht über der Kavität ein oder mehrere Bereiche aus nicht porösiziertem Halbleitermaterial angeordnet sind, deren Dicke größer ist als die Dicke der porösen Schicht. Durch diese Maßnahme lassen sich mehrere Vorteile erzielen. Zunächst kann dadurch bei der Herstellung der porösen Membranschicht vermieden werden, dass diese im Herstellungsverlauf am Kavitätsboden durch Kapillarkraft anklebt. Für den Fall einer Anwendung als z.B. Drucksensor bildet eine derartige Ausgestaltung einen Überlastschutz. Denn es wird nicht nur das Kleben der Schicht am Kavitätsboden vermieden, sondern auch verhindert, dass die poröse Schicht durch Kontakt mit dem Kavitätsboden deformiert und gegebenenfalls Material aus der porösen Schicht ausbricht. Das ausgebrochene Material könnte eine Blockade der Membranauslenkung verursachen. Zusätzlich können die nicht porösizierten Bereiche eine Art Stabilisierung der porösen Schicht, insbesondere bei der Herstellung der Kavität bewirken, insbesondere dann, wenn die nicht porösizierten Bereiche ein Gitternetzwerk in der porösen Schicht bilden. Eine solche Ausgestaltung erhöht auch für weitere Prozessschritte z.B. einem nachfolgenden Epitaxieschritt die mechanische Stabilität der porösen Schicht.

In einer bevorzugten Ausgestaltung der Erfindung sind die Bereiche inselförmig, d.h. ohne Verbindung zum Rand der Membran ausgestaltet. Beispielsweise umfassen die nicht porösizierten Bereiche eine Ringstruktur. Eine derartige Struktur reduziert überdies die Gefahr, dass ein Membranbruch im Einspannbereich während einer Anwendung z.B. bei Überlast auftritt, indem sich die Ringstruktur bei geeigneter Entfernung vom Rand der Membran am Boden der Kavität abstützt und eine Entlastung der Membran im Einspannbereich bewirkt.

Einer Beschädigung der Membran bei der Herstellung der Kavität kann von einem Halbleiterbauelement auch dadurch entgegengewirkt werden, dass der Randbereich in der porösen Membranschicht einen nicht porösizierten vorzugsweise die Membranschicht vollständig umgebenden Bereich aus Halbleitermaterial umfasst, der durch eine entsprechende Dotierung als Maskierschicht bei der Herstellung von porösiziertem Halbleitermaterial bzw. bei der Kavernenbildung dient und eine Dicke aufweist, die größer ist, als die Dicke der porösen Membranschicht einschließlich der Tiefe der Kavität. Durch diese Maßnahme erhält man eine ausgezeichnete Prozesskontrolle insbesondere bei der Ausbildung der Kavität, deren laterale Ausdehnung sich hierdurch nur wenig über die Tiefe ändert. Dies begünstigt ebenfalls die Vermeidung von Beschädigungen der porösen Membranschicht, da unkontrollierte Ätzvorgänge in lateraler Richtung vermieden werden.

### Beschreibung der Ausführungsbeispiele

Mehrere Ausführungsbeispiele der Erfindung sind in den Zeichnungen unter Angabe von weiteren Vorteilen und Einzelheiten näher erläutert. Es zeigen
- Figur 1: ein schematisches Schnittbild eines Siliziumträgers mit OMM-Membran,
- Figur 2: eine weitere Ausführungsform einer OMM-Membran-Struktur,
- Figur 3a und 3b: zu Figur 1 und 2 entsprechende schematische Schnittbilder, die die Ätzung einer Kavität oder Kaverne unterhalb einer porösen Schicht zur Erzeugung einer frei tragenden OMM-Membran veranschaulichen,
- Figur 4: ein zu den vorangegangenen Figuren entsprechendes Schnittbild einer weiteren Ausführungsform einer OMM-Membran-Struktur,
- Figur 5a bis 5d: vier Ausführungsformen einer OMM-Membran-Struktur in einer schematischen Draufsicht und
- Figur 6: ein schematisches Schnittbild einer ausschnittsweise dargestellten OMM-Membran-Struktur, das die Wirkungsweise einer zusätzlichen Auflagestruktur verdeutlicht.

### Beschreibung der Ausführungsbeispiele

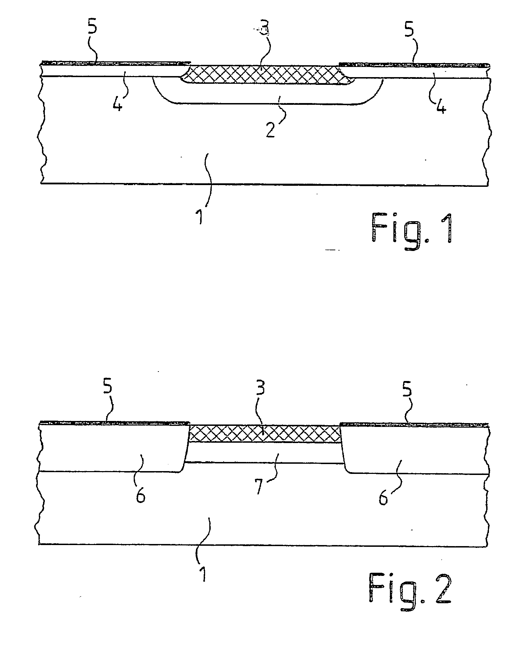

Figur 1 zeigt in einem schematischen Schnittbild einen Ausschnitt eines Siliziumträgers 1, in welchem eine Kavität 2 ausgebildet ist. Darüber befindet sich eine poröse Membranschicht 3, die von einer Maskierschicht 4 lateral begrenzt wird. In Figur 1 ist auf der Maskierschicht 4 eine weitere optionale Maskierschicht 5 dargestellt, die die Maskierschicht 4 schützt. Als optionale Maskierschicht kann eine Metallisierung oder ein Isolator verwendet werden.

Je nach Prozessführung kann die Membranschicht 3 aus n- oder p-dotiertem Silizium hergestellt werden. Die Kaverne 2 wird vorzugsweise auf der Grundlage von unterschiedlich p-dotiertem Silizium ausgebildet. Als Siliziumträgermaterial kann Bulk-Silizium oder unterschiedlich p-dotiertes Silizium dienen. Für eine Maskierschicht 4, die die poröse Membranschicht 3 begrenzt, wird vorzugsweise n-dotiertes Silizium eingesetzt.

Der Aufbau nach Figur 2 unterscheidet sich von dem nach Figur 1 dadurch, dass eine n-dotierte Maskierschicht 6 im Siliziumträgermaterial ausgebildet ist, die sich in der Tiefe über die Dicke der Membranschicht 3 als auch die Tiefe einer Kavität 7 erstreckt. Hierdurch ändert sich die Ätzfläche bei der Erzeugung der Kavität über die Tiefe nur unwesentlich, wodurch eine Prozesskontrolle bei deren Herstellung wesentlich vereinfacht ist.

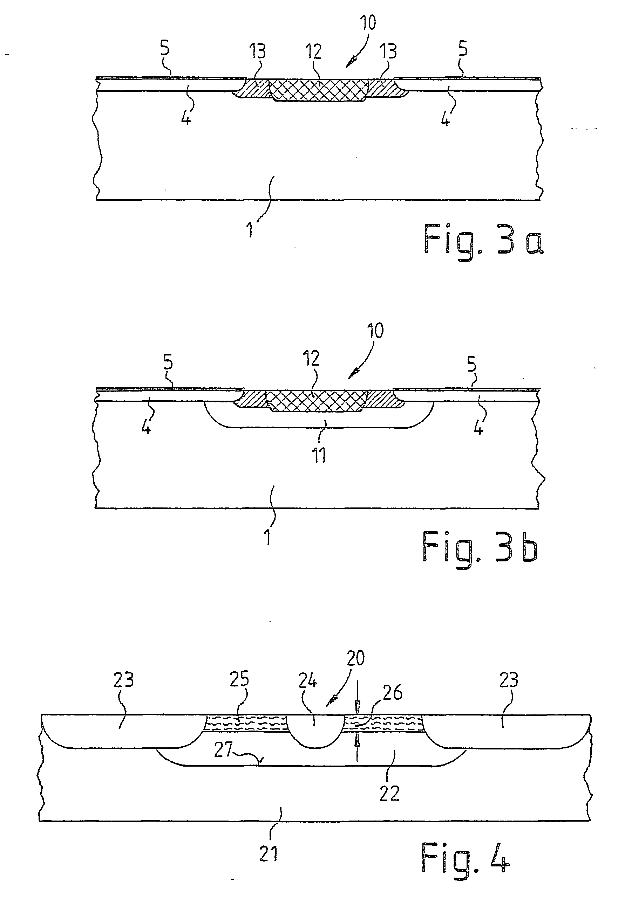

In Figur 3a und 3b ist die Ausbildung einer Membranschicht 10 mit darunter liegender Kavität 11 für den Fall dargestellt, dass das Halbleitermaterial bei der Herstellung der porösen Membranschicht 10 in lateraler Richtung unterschiedliche Dotierungsbereiche aufweist. Das hat zur Folge, dass im vorliegenden Beispiel im Membranmittenbereich 12 bei der Erzeugung von porösem Silizium größere Poren erzeugt wurden als im Membranrandbereich 13. Zusätzlich ist im Membranrandbereich durch entsprechende Prozessführung die Porosität der Schicht 10 geringer, was bei der weiteren Prozessführung für die Herstellung z.B. eines OMM-Drucksensors ein gutes epitaktisches Wachstum für eine umschließende Schicht ermöglicht.

Figur 3a zeigt den Zustand, dass gerade die unterschiedlich poröse Membranschicht 10 mit geeigneter Maskierung 4, 5 erzeugt wurde. Bei der anschließenden Herstellung der Kavität 11, so wie sie in Figur 3b dargestellt ist, begünstigt die großporige Struktur der Membranmitte eine gute Durchlässigkeit für Gas, das bei der Ätzung der Kavität entsteht. Hierdurch wird ein Gasstau unter der Membran vermieden, der diese noch bei der Herstellung der Kavität 11 zerstören könnte. Die für ein im Randbereich gutes epitaktisches Wachstum notwendige Kleinporigkeit der porösen Membranschicht 10 wird dennoch gewährleistet.

Figur 4 zeigt eine Ausführungsform einer OMM-Membran 20, die in einem Siliziumträger 21 über einer Kaverne 22 ausgebildet ist, welche im Unterschied zu den vorhergehend beschriebenen Membranschichten im Zentrum einen nicht porösizierten Bereich 24 innerhalb eines porösen Bereichs 25 besitzt. Dieser nicht porösizierte Bereich 24 entspricht n-dotierten Maskierbereichen 23 für die seitliche Begrenzung der porösen Membran und ist senkrecht zur lateralen Ausdehnung höher als die Dicke 26 des porösen Bereiches 25.

Das hat zur Folge, dass bei Auslenkung der Membran 20 deren porösizierten Bereiche 24, die sehr empfindlich sind, niemals den Kavernenboden 27 der Kaverne 22 berühren können.

Denn der nicht porösizierte Bereich 24 stellt einen Anschlag dar, der bei Überlastung am Kavernenboden 27 aufliegt und die Auslenkung begrenzt.

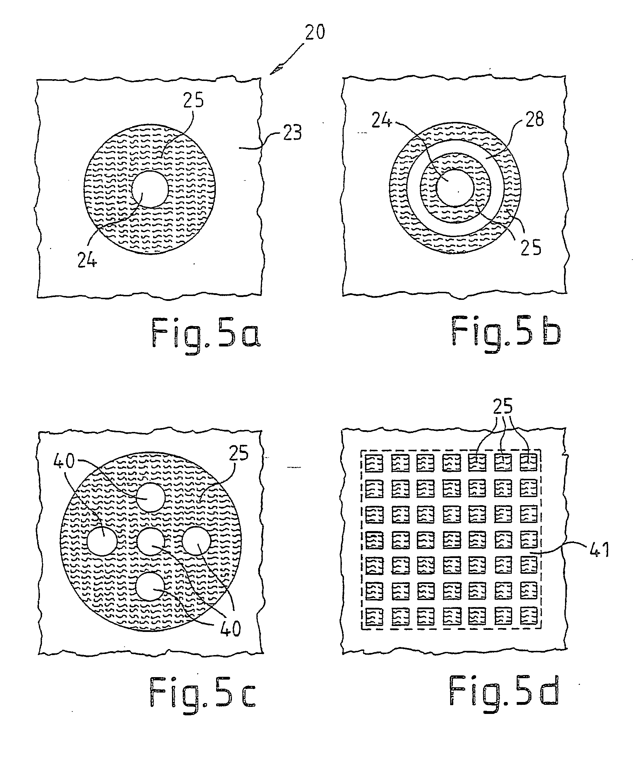

Figur 5a ist eine schematische Draufsicht auf eine entsprechend ausgebildete Membran 20.

Figur 5b unterscheidet sich von Figur 5a dadurch, dass zusätzlich zum nicht porösizierten Bereich 24 unmittelbar im Zentrum der Membran ein zusätzlicher nicht porösizierter Ringbereich 28 konzentrisch zum Zentrum der ansonsten kreisrunden porösizierten Bereiche 25 ausgebildet ist.

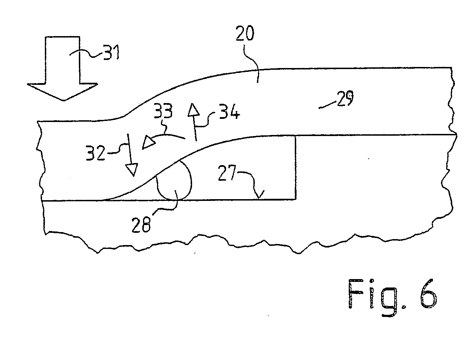

Der Vorteil einer derartigen Ringstruktur 28 soll in Figur 6 anhand eines schematischen Schnittbilds und Pfeilen 31 bis 35 veranschaulicht werden. Bei einer Druckbeaufschlagung, die eine Überlast für die poröse Membran 20 bedeutet und die schematisch durch den großflächigen Pfeil 31 symbolisiert ist, wird die Membran 20 in Richtung Kavernenboden 27 gepresst, was ein Einreißen der Membran 20 am Einspannbereich 29 zu Folge haben kann. Durch die Ringstruktur 28 findet jedoch eine Kraftumlenkung derart statt (siehe Pfeil 33), dass die Membran im Einspannbereich nach oben entlastet wird (siehe Pfeil 34), wenngleich eine Kraftwirkung nach unten (Pfeil 32) vorhanden ist. Insgesamt wird hierdurch ein Kerbriss am Einspannbereich 29 der Membran 20 vermieden.

Weitere Möglichkeiten nicht porösizierte Bereiche 40, 41 innerhalb poröser Bereiche 35 auszubilden, werden in den Draufsichten der Figuren 5c und 5d veranschaulicht. Insbesondere durch eine Gitterstruktur 41, so wie sie in Figur 5d dargestellt ist, lässt sich die Stabilität der porösen Membran sowohl bei der Herstellung als auch für den Anwendungsfall erheblich erhöhen.

## Patentansprüche

1. Verfahren zur Herstellung eines Halbleiterbauelements, insbesondere eines Membransensors, mit einem Halbleiterträger, bei welchem für die Ausbildung von frei tragenden Strukturen für das Bauelement eine poröse Membranschicht und eine Kavität unter der porösen Membranschicht erzeugt wird, wobei
- der Halbleiterträger (1) im Bereich der porösen Membranschicht (3) eine zum Bereich der späteren Kavität unterschiedliche Dotierung erhält, und
- das Halbleitermaterial der Membranschicht porösiziert wird, und
- das Halbleitermaterial unter dem porösiziertem Halbleitermaterial zur Bereitstellung der Kavität (2) entfernt oder teilweise entfernt und umgelagert wird, und
- der Halbleiterträger (1) im Bereich der porösen Membranschicht (3) in lateraler und/oder vertikaler Richtung eine unterschiedliche Dotierung erhält,
**dadurch gekennzeichnet, dass**
die Dotierung des Halbleitermaterials für den Membranrandbereich (13) und den Membranmittenbereich (12) derart gewählt wird, dass im Randbereich Mesoporen und im Mittenbereich Makroporen oder Mesoporen mit im Vergleich zum Randbereich höherer Porosität entstehen.

2. Verfahren nach Anspruch 1, **dadurch gekennzeichnet, dass** der Halbleitermaterialträger im Membranbereich (3) und im Bereich der späteren Kavität eine unterschiedliche Dotierung derart erhält, dass im Bereich der porösen Membranschicht Mesoporen und im Kavitätsbereich Nanoporen mit vergleichsweise höherer Porosität erzeugt werden, und dass in einem weiteren Schritt die nanoporöse Schicht entfernt oder teilweise entfernt und umgelagert wird.

3. Verfahren nach Anspruch 2, **dadurch gekennzeichnet, dass** zunächst die nanoporöse Schicht oxidiert und anschliessend die oxidierte Schicht durch Ätzen entfernt wird.

4. Verfahren nach einem der vorhergehenden Ansprüche, **dadurch gekennzeichnet, dass** zur besseren Einstellung der Stromdichte beim Ätzen des Halbleitermaterials zur Herstellung des porösen Membranbereichs (3) die Rückseite des Halbleiterträgers (1) beleuchtet wird.

5. Verfahren nach einem der Ansprüche 1 bis 4, **dadurch gekennzeichnet, dass** zur besseren Einstellung der Stromdichte beim Ätzen des Halbleitermaterials während des Elektropolierens zur Herstellung der Kavität (2) bzw. zur Erzeugung einer porösen Schicht im Bereich der späteren Kavität (2) die Rückseite des Halbleiterträgers (1) beleuchtet wird.

6. Verfahren nach einem der vorhergehenden Ansprüche, **dadurch gekennzeichnet, dass** durch Einstellen der Stromdichte und/oder Veränderung des Ätzmediums im Membranbereich eine Porosität von ungefähr 10 bis 30 % und im späteren Kavernenbereich eine Porosität von grösser 80 % im Halbleitermaterial erzeugt wird.

7. Halbleiterbauelement, insbesondere Membransensor, mit einem Träger (1) aus Halbleitermaterial, das zur Ausbildung von Halbleiterbauelementstrukturen eine Membran (3) und eine unter der Membran angeordnete Kavität (2) aufweist, wobei
- die Membran eine Schicht (3) aus porösiziertem und gegebenenfalls nachbehandeltem Halbleitermaterial umfasst, und
- der Grad der Porosität der Schicht (3) in lateraler und/oder vertikaler Richtung gezielt unterschiedlich ist,
**dadurch gekennzeichnet, dass**
die Porengrösse in der Schicht (3) im Membranrandbereich (13) geringer ist als im Membranmittenbereich (12).

8. Halbleiterbauelement nach Anspruch 7, **dadurch gekennzeichnet, dass** das Schichtmaterial im Membranrandbereich (13) mesoporös ist.

9. Halbleiterbauelement nach einem der Ansprüche 7 oder 8, **dadurch gekennzeichnet, dass** das Schichtmaterial im Membranmittenbereich (12) meso- oder makroporös ist.

10. Halbleiterbauelement nach Anspruchs 7, **dadurch gekennzeichnet, dass** die poröse Schicht (3) durchgehend Makroporen aufweist.

11. Halbleiterbauelement nach einem der Ansprüche 7 bis 10, **dadurch gekennzeichnet, dass** innerhalb der porösen Membranschicht (3) ein Bereich oder mehrere Bereiche aus nicht porösiziertem Halbleitermaterial angeordnet ist bzw. sind, dessen bzw. deren Dicke größer ist als die Dicke der porösen Membranschicht (3,20).

12. Halbleiterbauelement nach Anspruch 11, **dadurch gekennzeichnet, dass** ein Bereich (24) inselförmig ausgestaltet ist

13. Halbleiterbauelement nach einem der Ansprüche 11 oder 12, **dadurch gekennzeichnet, dass** ein nicht porösizierter Bereich (24) im Symmetriezentrum der porösen Membranschicht (3,20) angeordnet ist.

14. Halbleiterbauelement nach einem der Ansprüche 10 bis 13, **dadurch gekennzeichnet, dass** ein nicht porösizierter Bereich (28) ringförmig ist

15. Halbleiterbauelement nach einem der Ansprüche 7 bis 14, **dadurch gekennzeichnet, dass** der Randbereich der porösen Membranschicht (3) einen nicht porösizierten, vorzugsweise die Membranschicht (3,20) vollständig umgebenden Bereich (6) aus Halbleitermaterial umfasst, der als Maskierschicht beim Ätzen dient und eine Dicke aufweist, die größer ist als die Dicke der porösen Membranschicht (3) einschließlich der Tiefe der Kavität (7).

## Claims

1. Method for producing a semiconductor component, in particular a membrane sensor, having a semiconductor carrier, in which, for the formation of self-supporting structures for the component, a porous membrane layer is produced and a cavity is produced below the porous membrane layer, wherein
- the semiconductor carrier (1) acquires, in the region of the porous membrane layer (3), a different doping relative to the region of the later cavity,
- the semiconductor material of the membrane layer is porosified, and
- the semiconductor material below the porosified semiconductor material is removed or partly removed and rearranged in order to provide the cavity (2), and
- the semiconductor carrier (1) acquires, in the region of the porous membrane layer (3), a different doping in a lateral and/or vertical direction,
**characterized in that**
the doping of the semiconductor material for the membrane edge region (13) and the membrane central region (12) is chosen in such a way that mesopores arise in the edge region and macropores or mesopores having a higher porosity in comparison with the edge region arise in the central region.

2. Method according to Claim 1, **characterized in that** the semiconductor material carrier acquires a different doping in the membrane region (3) and in the region of the later cavity in such a way that mesopores are produced in the region of the porous membrane layer and nanopores having comparatively higher porosity are produced in the cavity region, and **in that** in a further step, the nanoporous layer is removed or partly removed and rearranged.

3. Method according to Claim 2, **characterized in that** firstly the nanoporous layer is oxidized and subsequently the oxidized layer is removed by etching.

4. Method according to any of the preceding claims, **characterized in that** the rear side of the semiconductor carrier (1) is illuminated for the purpose of better setting the current density during the etching of the semiconductor material for the purpose of producing the porous membrane region (3).

5. Method according to any of Claims 1 to 4, **characterized in that** the rear side of the semiconductor carrier (1) is illuminated for the purpose of better setting the current density during the etching of the semiconductor material during the electropolishing for the purpose of producing the cavity (2) or for the purpose of producing a porous layer in the region of the later cavity (2).

6. Method according to any of the preceding claims, **characterized in that** by setting the current density and/or varying the etching medium in the membrane region a porosity of approximately 10 to 30% and in the later cavity region a porosity of greater than 80% are produced in the semiconductor material.

7. Semiconductor component, in particular membrane sensor, having a carrier (1) composed of semiconductor material, which, for forming semiconductor component structures, has a membrane (3) and a cavity (2) arranged below the membrane, wherein
- the membrane comprises a layer (3) composed of porosified semiconductor material, which if appropriate is subjected to aftertreatment, and
- the degree of porosity of the layer (3) differs in a targeted manner in a lateral and/or vertical direction,
**characterized in that**
the pore size in the layer (3) is smaller in the membrane edge region (13) than in the membrane central region (12).

8. Semiconductor component according to Claim 7, **characterized in that** the layer material in the membrane edge region (13) is mesoporous.

9. Semiconductor component according to either of Claims 7 and 8, **characterized in that** the layer material in the membrane central region (12) is meso-or macroporous.

10. Semiconductor component according to Claim 7, **characterized in that** the porous layer (3) has macropores throughout.

11. Semiconductor component according to any of Claims 7 to 10, **characterized in that** one region or a plurality of regions composed of non-porosified semiconductor material is or are arranged within the porous membrane layer (3), the thickness of said region or regions being greater than the thickness of the porous membrane layer (3, 20).

12. Semiconductor component according to Claim 11, **characterized in that** a region (24) is configured in an insular fashion.

13. Semiconductor component according to either of Claims 11 and 12, **characterized in that** a non-porosified region (24) is arranged in the centre of symmetry of the porous membrane layer (3, 20).

14. Semiconductor component according to any of Claims 10 to 13, **characterized in that** a non-porosified region (28) is ring-shaped.

15. Semiconductor component according to any of Claims 7 to 14, **characterized in that** the edge region of the porous membrane layer (3) comprises a non-porosified region (6) composed of semiconductor material, which region preferably completely surrounds the membrane layer (3, 20) and serves as a masking layer during etching and has a thickness that is greater than the thickness of the porous membrane layer (3) including the depth of the cavity (7).

## Revendications

1. Procédé de fabrication d'un composant semi-conducteur, en particulier d'un capteur à membrane, qui présente un support semi-conducteur pour lequel une couche poreuse de membrane et une cavité située en dessous de la couche poreuse de membrane sont formées pour réaliser dans le composant des structures portantes libres,
le support semi-conducteur (1) contenant au niveau de la couche poreuse de membrane (3) un dopage différent de celui de la zone occupée par la future cavité et
le matériau semi-conducteur de la couche de membrane étant rendu poreux,
le matériau semi-conducteur étant enlevé, enlevé partiellement et réagencé en dessous du matériau semi-conducteur rendu poreux en vue de former la cavité (2) et
le support semi-conducteur (1) recevant au niveau de la couche poreuse de membrane (3) un dopage variant dans la direction latérale et/ou la direction verticale, **caractérisé en ce que**
les dopages du matériau semi-conducteur pour la bordure (13) de la membrane et pour la partie centrale (12) de la membrane sont sélectionnés de manière à former des mésopores dans la bordure et des macropores ou des mésopores dans la partie centrale, avec une porosité plus élevée dans la partie centrale que dans la bordure.

2. Procédé selon la revendication 1, **caractérisé en ce que** le support en matériau semi-conducteur reçoit des dopages différents dans la partie (3) occupée par la membrane et dans celle occupée par la future cavité, **en ce que** des mésopores sont formés au niveau de la couche poreuse de membrane et des nanopores à porosité plus élevée dans la zone occupée par la cavité et **en ce que** dans une autre étape, la couche nanoporeuse est enlevée, partiellement enlevée et réagencée.

3. Procédé selon la revendication 2, **caractérisé en ce que** la couche nanoporeuse est d'abord oxydée, la couche oxydée étant ensuite enlevée par gravure.

4. Procédé selon l'une des revendications précédentes, **caractérisé en ce que** pour mieux ajuster la densité du courant lors de la gravure du matériau semi-conducteur destiné à réaliser la partie poreuse (3) occupée par la membrane, le dos du support semi-conducteur (1) est éclairé.

5. Procédé selon l'une des revendications 1 à 4, **caractérisé en ce que** pour mieux ajuster la densité du courant lors de la gravure du matériau semi-conducteur pendant l'électropolissage destiné à réaliser la cavité (2) ou à former une couche poreuse au niveau de la future cavité (2), le dos du support semi-conducteur (1) est éclairé.

6. Procédé selon l'une des revendications précédentes, **caractérisé en ce que** par ajustement de la densité du courant et/ou modification du fluide de gravure, une porosité d'environ 10 à 30 % est réalisée au niveau de la membrane et une porosité supérieure à 80 % au niveau de la future cavité dans le matériau semi-conducteur.

7. Composant semi-conducteur, en particulier capteur à membrane, doté d'un support (1) en matériau semi-conducteur qui présente pour former des structures de composant semi-conducteur une membrane (3) et une cavité (2) disposée sous la membrane,
la membrane comportant une couche (3) en matériau semi-conducteur rendu poreux et éventuellement encore traité et
le taux de porosité de la couche (3) variant de manière contrôlée dans la direction latérale et/ou dans la direction verticale,
**caractérisé en ce que**
la taille des pores de la couche (3) dans la bordure (13) de la membrane est plus petite que dans la partie centrale (12) de la membrane.

8. Composant semi-conducteur selon la revendication 7, **caractérisé en ce que** le matériau de la couche est mésoporeux dans la bordure (13) de la membrane.

9. Composant semi-conducteur selon l'une des revendications 7 ou 8, **caractérisé en ce que** le matériau de la couche est mésoporeux ou macroporeux dans la partie centrale (12) de la membrane.

10. Composant semi-conducteur selon la revendication 7, **caractérisé en ce que** la couche poreuse (3) est traversée par des macropores.

11. Composant semi-conducteur selon l'une des revendications 7 à 10, **caractérisé en ce qu'**une ou plusieurs parties en matériau semi-conducteur non rendu poreux et dont l'épaisseur est supérieure à l'épaisseur de la couche poreuse (3, 20) de la membrane sont disposées à l'intérieur de la couche poreuse (3) de la membrane.

12. Composant semi-conducteur selon la revendication 11, **caractérisé en ce qu'**une zone (24) est configurée en îlot.

13. Composant semi-conducteur selon l'une des revendications 11 ou 12, **caractérisé en ce qu'**une partie (24) non rendue poreuse est disposée au centre de symétrie de la couche poreuse (3, 20) de la membrane.

14. Composant semi-conducteur selon l'une des revendications 10 à 13, **caractérisé en ce qu'**une partie (28) non rendue poreuse est annulaire.

15. Composant semi-conducteur selon l'une des revendications 7 à 14, **caractérisé en ce que** la bordure de la couche poreuse (3) de la membrane comporte une partie (6) en matériau semi-conducteur non rendu poreux, qui entoure de préférence complètement la couche (3, 20) de la membrane, sert de couche de masquage lors de la gravure et présente une épaisseur supérieure à l'épaisseur de la couche poreuse (3) de la membrane, en ce compris la profondeur de la cavité (7).
